Europäisches Patentamt

**European Patent Office**

Office européen des brevets

(19)

(11) Numéro de publication: **0 175 611**
**B1**

(12) # FASCICULE DE BREVET EUROPEEN

(45) Date de publication du fascicule du brevet:
**10.01.90**

(51) Int. Cl.⁴: **G 01 N 24/08**

(21) Numéro de dépôt: **85401746.4**

(22) Date de dépôt: **06.09.85**

(54) **Installation d'imagerie par résonance magnétique nucléaire.**

(30) Priorité: **14.09.84 FR 8414152**

(43) Date de publication de la demande:
**26.03.86 Bulletin 86/13**

(45) Mention de la délivrance du brevet:
**10.01.90 Bulletin 90/2**

(84) Etats contractants désignés:
**DE GB IT NL**

(56) Documents cités:
**EP-A- 0 109 633**
**GB-A- 2 041 537**
**US-A- 4 021 726**

**JOURNAL OF PHYSICS E: SCIENTIFIC INSTRUMENTS, vol. 4, no. 4, avril 1976, pages 271-278, London, GB; P. MANSFIELD et al.: "Fast scan proton density imaging by NMR"**
**IEEE TRANSACTIONS ON MEDICAL IMAGING, vol. MI-2, no. 4, décembre 1983, pages 169-175, IEEE, New York, US; A. CAPRIHAN; "Effect of amplitude modulation on selective excitation in NMR imaging"**

(73) Titulaire: **GENERAL ELECTRIC CGR S.A., 13, Square Max-Hymans, F-75015 Paris (FR)**

(72) Inventeur: **Breton, Eric André, THOMSON-CSF SCPI 173, bld. Haussmann, F-75379 Paris Cedex 08 (FR)**

(74) Mandataire: **Ballot, Paul Denis Jacques et al, Cabinet Ballot-Schmit 7, rue le Sueur, F-75116 Paris (FR)**

## Description

L'invention se rapporte à une installation d'imagerie par résonance magnétique nucléaire et concerne plus particulièrement la conformation du signal radiofréquence d'excitation pour obtenir une sélection de coupe de caractéristiques voulues, notamment la sélection d'une coupe (c'est-à-dire une tranche plane d'épaisseur choisie du corps à examiner) ayant, dans l'espace, des limites aussi précises et nettes que possible.

Une installation d'imagerie par résonance magnétique nucléaire classique comprend un aimant pour créer un champ magnétique uniforme dans une région de l'espace où l'on place le corps à examiner, des moyens pour superposer à ce champ uniforme un gradient de champ orienté suivant une direction choisie de l'espace, les caractéristiques du gradient étant modifiées au cours des séquences successives d'acquisition des données et des moyens d'émission radiofréquence pour créer dans ladite région de l'espace un champ tournant susceptible de faire «basculer» les spins de certains noyaux (le plus souvent des atomes d'hydrogène) du corps à examiner. Les conditions de résonance magnétique nucléaire pour lesquelles on peut observer le basculement des spins sont déterminées par la valeur locale du champ magnétique et la fréquence de l'onde électromagnétique d'excitation. A titre d'exemple, pour l'hydrogène, les conditions de résonance sont réunies pour une émission radiofréquence à 6,4 MHz et un champ magnétique de 1500 Gauss ou pour une émission radiofréquence de 64 MHz et un champ magnétique de 15000 Gauss.

La superposition du champ magnétique constant et d'un gradient dans la région de l'espace précitée limite les conditions de résonance à une tranche plane (ci-après quelquefois appelée «plan») de faible épaisseur, c'est-à-dire une coupe choisie du corps à imager, de sorte que les spins des noyaux étudiés de cette coupe soient les seuls à basculer et par là même les seuls à réémettre ensuite un signal radiofréquence mesurable. En procédant à un grand nombre de séquences d'émission-réception, on rassemble un ensemble de données suffisant pour reconstituer l'image de la coupe. Pour que l'image soit de bonne qualité, on peut chercher à obtenir une coupe dont les limites soient aussi nettes que possible, c'est-à-dire à mettre en œuvre des séquences d'émission-réception telles que les atomes situés au voisinage de la tranche du corps dont on cherche à reconstituer l'image, ne soient pas ou peu excités pour que leur contribution dans le signal radiofréquence réémis soit la plus faible possible. Or la «forme» de la sélection de coupe varie en fonction de l'enveloppe du signal radiofréquence provoquant le basculement des spins.

Jusqu'à présent, on a toujours supposé que la «forme» de la sélection de coupe, qui peut se définir comme étant la densité de spins excités le long d'un axe perpendiculaire au plan de la coupe, était la transformée de Fourier de la «forme» de l'impulsion d'excitation radiofréquence (c'est-à-dire l'enveloppe de ce signal). Ceci a dicté le choix d'une enveloppe de forme sinus-cardinal

sinus-cardinal de

$$x = \sin c \, (x) = \frac{\sin \pi x}{\pi x}$$

représentant la transformée de Fourier inverse d'un créneau. Un créneau à flancs droits est en effet l'image d'une transition optimale entre le plan de coupe sélectionné et le reste de la région de l'espace où règne le champ magnétique. Une telle solution est décrite dans IEEE TRANSACTIONS ON MEDICAL IMAGING, Vol. MI-2, no 4, décembre 1983, pages 169–175. Dans cette publication on a même pondéré la forme en sinus cardinal par des gaussiennes. En fait les résultats se sont montrés décevants et la forme de la sélection de coupe obtenue avec une impulsion radiofréquence de type sinus-cardinal n'est pas complètement satisfaisante.

L'invention découle de la constatation que la forme de la sélection de coupe n'est pas exactement la transformée de Fourier de la forme de l'impulsion radiofréquence et de l'hypothèse que la transformation f donnant la forme de la sélection de coupe à partir de la forme de l'impulsion radiofréquence est cependant involutive soit $f^{-1} = f$.

Cette hypothèse ayant été vérifiée par l'expérience, il est devenu possible de redéfinir une forme de sélection de coupe de la façon suivante:
- identifier (par la mesure ou le calcul) la forme de sélection de coupe résultant de l'application, au cours d'une séquence d'émission-réception, d'une impulsion radiofréquence d'excitation dont l'enveloppe est représentative de la sélection de coupe désirée;
- utiliser cette forme de la sélection de coupe ou une forme déduite de celle-ci en tant qu'enveloppe du signal radiofréquence dans les séquences d'émission-réception permettant de réunir l'ensemble des informations nécessaires à la reconstruction de l'image d'au moins un plan de coupe.

Pour certaines formes simples d'enveloppe d'impulsion radiofréquence, l'identification de la forme de sélection de coupe peut se faire par le calcul, notamment à l'aide d'un programme représentant le fonctionnement de l'installation d'imagerie. Dans tous les cas, elle peut se faire par la mesure, selon une procédure qui sera indiquée plus loin.

Dans cet esprit, l'invention concerne donc aussi une installation d'imagerie par résonance magnétique nucléaire, comprenant des moyens pour engendrer un champ magnétique sensiblement uniforme dans une région de l'espace, des moyens pour superposer à ce champ des gradients de champ de caractéristiques différentes choisies au cours de séquences successives d'acquisition de données et des moyens d'émission radiofréquence pour émettre au moins une impulsion radiofréquence au cours de chaque séquence, et des moyens de modulation pour donner à ladite impulsion radiofréquence une enveloppe temporelle, où cette enveloppe est déduite géométriquement du profil de coupe qui résulterait de l'application d'une impulsion radiofréquence d'enveloppe représentative du profil de coupe désirée.

Le plus souvent, dans la pratique, la forme de sélection de coupe désirée est un créneau puisqu'on cherche à faire basculer les spins des noyaux d'hydrogène situés dans une mince «tranche» du corps à examiner tout en excitant le moins possible ceux qui se trouvent de part et d'autre de celle-ci. Par conséquent, l'enveloppe de l'impulsion radiofréquence représentative de la forme de sélection de coupe désirée définie ci-dessus, est un créneau et pour ce type d'impulsion relativement simple, il est possible de calculer la forme de sélection de coupe résultante. Cette méthode de calcul est explicitée dans un article de la revue américaine «Journal of Magnetic Resonance» volume No 33, publiée en 1979. Cette méthode de calcul est explicitée pour deux types d'impulsion radiofréquence en créneau, l'une calibrée pour faire basculer les spins de 90° et l'autre pour les faire basculer de 180°. On sait en effet que dans les séquences d'acquisition des données mettant en œuvre le phénomène d'écho de spin, il est nécessaire, au cours d'une même séquence d'acquisition, d'appliquer successivement une impulsion d'excitation calibrée pour un basculement des spins de 90° puis une impulsion d'excitation calibrée pour un basculement des spins de 180°. On peut encore améliorer les résultats en déduisant l'enveloppe de l'impulsion radiofréquence de la forme de sélection de coupe identifiée comme indiqué ci-dessus. Il s'est ainsi révélé avantageux de multiplier la forme d'enveloppe par une gaussienne et/ou de limiter la durée du signal radiofréquence dans le temps, c'est-à-dire de tronquer ladite enveloppe de part et d'autre de son amplitude maximum.

Ainsi des résultats particulièrement satisfaisantes ont été obtenus en utilisant une enveloppe F(t) pour l'impulsion radiofréquence de la forme:

1) pour faire basculer les spins de 90° dans la coupe sélectionnée

$$F(t) = A_1 \sin c \left(B_1 \sqrt{C_1 + X^2}\right) \exp\left(-D_1 X^2\right)$$

X est une variable réduite telle que

$$X = t - \frac{T90}{2}$$

t étant le temps avec
$t \in [0, T90]$
l'enveloppe est donc tronquée en dehors de cet intervalle de temps T90 représente un intervalle de temps tel que

$$\omega_1 T90 = \frac{\pi}{2} \qquad (1)$$

$\omega_1$ étant la vitesse de rotation des spins sous l'effet de la composante utile du champ tournant engendré par l'impulsion radiofréquence. $A_1$, $B_1$, $C_1$ et $D_1$ sont des paramètres de la fonction.

2) Pour faire basculer les spins de 180° dans la coupe sélectionnée

$$F(t) = - A_2 \frac{\cos B_2 \sqrt{C_2 + X^2}}{B_2^2 (C_2 + X^2)} \exp\left(-D_2 X^2\right)$$

$$\text{avec } X = t - \frac{T180}{2}$$

et $t \in [0, T180]$
$A_2$, $B_2$, $C_2$ et $D_2$ sont des paramètres constants de la fonction et T180 est un intervalle de temps tel que

$$\omega_1 T180 = \pi \quad (2)$$

Dans la pratique, T90 et T180 sont des valeurs choisies et on ajuste les paramètres $A_1$, $A_2$ (liés à $\omega_1$ par une relation de proportionnalité) pour que les relations (1) et (2) soient satisfaites, respectivement.

Pour un mode de réalisation donné, on a choisi les paramètres suivants:

| | |
|---|---|
| $B_1 = 1{,}088$ | $B_2 = 8{,}579$ |
| $C_1 = 0{,}2320$ | $C_2 = 0{,}134$ |
| $D_1 = 0{,}578$ | $D_2 = 0{,}470$ |
| $T_{90} = 3{,}4$ ms | $T_{180} = 2{,}7$ ms |

$A_1$ et $A_2$ sont des facteurs d'amplitude qui dépendent notamment du corps à examiner; ils sont donc ajustés à chaque fois.

La figure 1 est un graphe qui résume la procédure de détermination de l'enveloppe du signal radiofréquence, telle que décrite ci-dessus.

La figure 2 est un schéma-bloc d'une partie de l'installation d'imagerie conforme à l'invention illustrant les moyens pour élaborer un signal radiofréquence d'enveloppe prédéterminée.

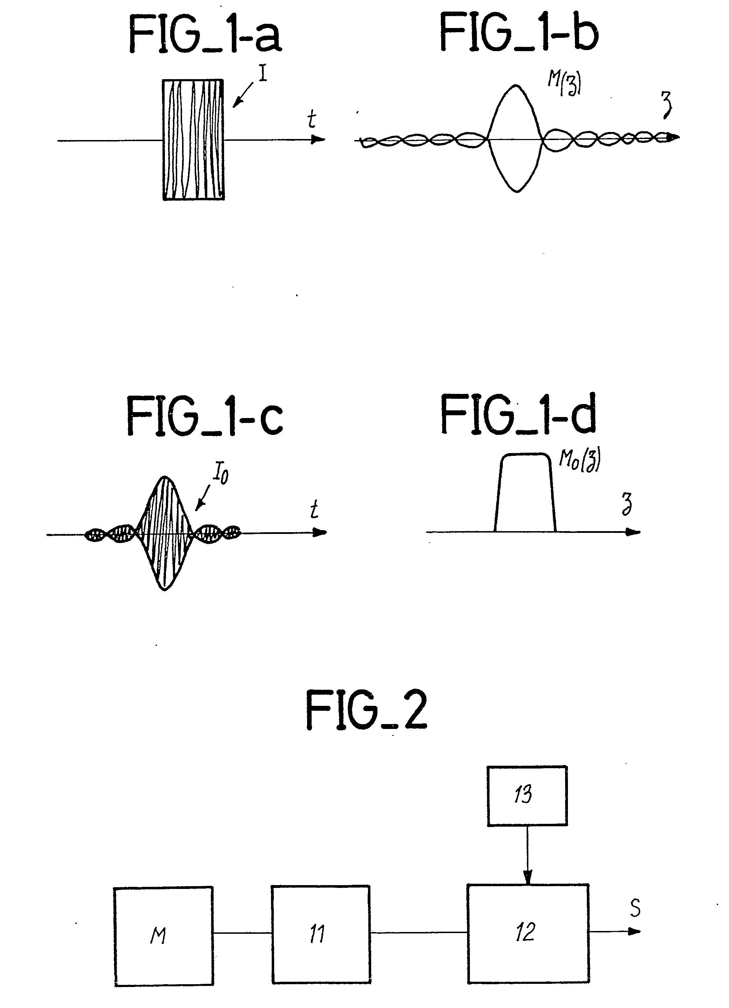

En se référant à la figure 1, I est la forme de l'enveloppe d'une impulsion radiofréquence d'excitation représentative de la forme de la sélection de coupe voulue. I a donc la forme d'un créneau à l'intérieur duquel «s'inscrit» le signal radiofréquence. A défaut des méthodes de calcul mentionnées ci-dessus pour identifier la forme de la sélection de coupe résultant de l'utilisation du créneau I, on pourra utiliser les moyens mêmes de l'installation d'imagerie par résonance magnétique nucléaire pour restituer un signal représentatif de la sélection de coupe obtenue avec l'impulsion I. Pour cela, il suffit de mettre en œuvre une séquence de test au cours de laquelle l'impulsion I (figure 1a) est engendrée en présence d'un gradient de sélection appliqué suivant un axe (Oz par exemple) pour sélectionner un plan de coupe perpendiculaire à cet axe. La séquence est poursuivie en inversant le gradient et en le maintenant pendant tout le temps de réception du signal émis en retour. Ce signal est échantillonné et appliqué à l'entrée d'un transformateur de Fourier. La visualisation de cette transformée de Fourier représente la forme de la sélection de coupe M(z) (voir figure b). Etant donné que la transformation est involutive M(z) peut être utilisé pour déduire une forme d'enveloppe du signal radiofréquence dont la durée ne soit pas trop importante. Cette enveloppe Io est représentée à la figure 1c. C'est une forme dérivée de celle de la figure 1b par multiplication par une gaussienne et troncature. L'utilisation de cette forme en tant qu'enveloppe du signal radiofréquence donne une forme de sélection de coupe Mo(z) dont l'allure est celle de la figure 1d. La même procédure peut être utilisée pour contrôler à postériori la forme de la sélection de coupe en réponse à une impulsion radiofréquence d'enveloppe choisie.

En se référant à la figure 2, l'installation comporte une mémoire numérique M renfermant point par point la courbe de la figure 1c. Un échantillonnage de 200 points avec une résolution de 9 bits (+ le signe) en intensité donne des résultats satisfaisants. Cette mémoire est lue à chaque émission d'une impulsion radiofréquence. Les informations numériques représentatives de l'allure de l'enveloppe sont adressées à l'entrée d'un convertisseur Numérique-Analogique 11 dont la sortie est reliée à une entrée de modulation d'un modulateur 12. Ce dernier reçoit le signal radiofréquence émis par un générateur 13 et la sortie S du modulateur est reliée aux antennes du système d'imagerie par résonance magnétique nucléaire via une chaîne d'amplification appropriée.

Bien que l'invention décrite ci-dessus fasse référence à une forme de sélection de coupe souhaitée la plus proche possible d'un créneau (ce qui correspond aux préoccupations actuelles des constructeurs) il est clair que l'invention vise aussi l'élaboration d'un signal radiofréquence aboutissant à une forme de sélection de coupe différente, la méthodologie étant applicable dans tous les cas, notamment grâce à la procédure de test décrite ci-dessus, permettant d'identifier expérimentalement la forme de sélection de coupe obtenue pour n'importe quelle enveloppe de signal radiofréquence.

**Revendications**

1. Installation d'imagerie par résonance magnétique nucléaire, comprenant des moyens pour engendrer un champ magnétique sensiblement uniforme dans une région de l'espace, des moyens pour superposer à ce champ des gradients de champ de caractéristiques différentes choisies, au cours de séquences successives d'acquisition de données, des moyens d'émission radiofréquence pour émettre au moins une impulsion radiofréquence au cours de chaque séquence, et des moyens de modulation (M, 11, 12) pour donner à ladite impulsion radiofréquence une enveloppe temporelle, cette enveloppe étant déduite géométriquement du profil de coupe qui résulterait de l'application d'une impulsion radiofréquence dont l'enveloppe serait géométriquement représentative du profil de coupe désiré.

2. Installation selon la revendication 1, caractérisée en ce que ladite enveloppe a été déduite de la forme de sélection de coupe qui résulterait de l'application d'une impulsion radiofréquence d'enveloppe représentative de la forme de sélection de coupe désirée en la multipliant par une gaussienne et/ou en la tronquant symétriquement de part et d'autre de son amplitude maximale.

3. Installation selon la revendication 1 ou 2, caractérisée en ce que ladite enveloppe d'un signal radiofréquence est calibrée pour faire basculer les spins de 90°, et est de la forme:

$$F(t) = A_1 \sin c \left(B_1 \sqrt{C_1 + X^2}\right) \exp\left(-D_1 X^2\right)$$

$$\text{avec } X = t - \frac{T90}{2} \text{ et } t \, \varepsilon \, [O, T90]$$

$A_1$, $B_1$, $C_1$, $D_1$, et T90 étant des paramètres prédéterminés.

4. Installation selon la revendication 1 ou 2, caractérisé en ce que ladite enveloppe d'un signal radiofréquence est calibrée pour faire basculer les spins de 180°, et est de la forme:

$$F(t) = -A_2 \frac{\cos B_2 \sqrt{C_2 + X^2}}{B_2^2 (C_2 + X^2)} \exp\left(-D_2 X^2\right)$$

$$\text{avec } X = t - \frac{T180}{2} \text{ et } t \, \varepsilon \, [o, T180]$$

$A_2$, $B_2$, $C_2$, $D_2$ et T180 étant des paramètres prédéterminés.

5. Procédé de détermination de la forme d'une première enveloppe temporelle de l'impulsion radiofréquence utilisée dans une installation d'imagerie par résonance magnétique nucléaire, ladite installation comprenant des moyens pour engendrer un champ magnétique sensiblement uniforme dans une région de l'espace, des moyens pour superposer à ce champ des gradients de champ de caractéristiques différentes choisies, au cours de séquences successives d'acquisition de données, des moyens d'émission radiofréquence pour appliquer au moins une impulsion radiofréquence ayant la forme de cette première enveloppe au cours de chaque séquence, et des moyens de modulation (M, 11, 12) pour donner à ladite impulsion radiofréquence cette première enveloppe temporelle, caractérisée en ce qu'on détermine une deuxième enveloppe temporelle (figure 1a) correspondant géométriquement à la forme désirée pour un profil (figure 1d) de coupe, et ce qu'on choisit la forme (figure 1c) de la première enveloppe de l'impulsion radiofréquence à appliquer à partir de la forme (figure 1b) du profil de coupe déterminé par l'application d'une impulsion ayant comme enveloppe temporelle ladite deuxième enveloppe.

6. Procédé selon la revendication 5, caractérisé en ce que la forme du profil de coupe est déterminée par mesure, grâce à l'installation d'imagerie de résonance magnétique nucléaire.

7. Procédé selon la revendication 6, caractérisé en ce que la forme (figure 1b) de la première enveloppe est déterminé par calcul.

8. Procédé selon l'une quelconque des revendications 5 à 7, caractérisé en ce que la première enveloppe de l'impulsion radiofréquence est déduite de la forme du profil de coupe déterminé premièrement par l'application de la deuxième enveloppe de l'impulsion radiofréquence, et deuxièmement par multiplication par une gaussienne et/ou par un troncage symétrique de part et d'autre de l'amplitude maximum.

## Patentansprüche

1. Einrichtung zur Bilderzeugung durch magnetische Kernresonanz, die Mittel, um ein im wesentlichen gleichförmiges Feld in einer Raumzone zu erzeugen, Mittel, um diesem Feld Feldgradienten mit unterschiedlich gewählten Eigenschaften beim Ablauf der aufeinanderfolgenden Datenerfassungssequenzen zu überlagern, Mittel zur Radiofrequenzausstrahlung, um mindestens einen Radiofrequenzimpuls beim Ablauf jeder Sequenz auszustrahlen, und Modulationsmittel (M, 11, 12) enthält, um dem Radiofrequenzimpuls eine temporäre Hüllkurve zu geben, wobei diese Hüllkurve vom Schnittprofil geometrisch abgeleitet ist, welches Ergebnis der Anwendung eines Radiofrequenzimpulses wäre, dessen Hüllkurve geometrisch typisch für das gewünschte Schnittprofil sein würde.

2. Einrichtung nach Anspruch 1, dadurch gekennzeichnet, dass die Hüllkurve von der Form der Schnittauswahl abgeleitet wurde, die Ergebnis der Anwendung eines Radiofrequenzimpulses mit einer typischen Hüllkurve der gewünschten Form der Schnittauswahl sein würde, indem man sie mit einer Gaussfunktion multipliziert und/oder indem man sie auf beiden Seiten symmetrisch zu ihrer Maximalamplitude abschneidet.

3. Einrichtung nach Anspruch 1 oder 2, dadurch gekennzeichnet, dass die Hüllkurve eines Radiofrequenzsignals eingestellt ist, um den Spin um 90° kippen zu lassen, und von der Form ist:

$$F(t) = A_1 \sin c \left( B_1 \sqrt{C_1 + X^2} \right) \exp\left( - D_1 X^2 \right)$$

$$\text{mit } X = t - \frac{T90}{2} \text{ und } t \, \varepsilon \, [o, T90]$$

wobei $A_1$, $B_1$, $C_1$, $D_1$ und T90 vorbestimmte Parameter sind.

4. Einrichtung nach Anspruch 1 oder 2, dadurch gekennzeichnet, dass die Hüllkurve eines Radiofrequenzsignals eingestellt ist, um den Spin 180° zu kippen, und von der Form ist:

$$F(t) = - A_2 \frac{\cos B_2 \sqrt{C_2 + X^2}}{B_2^2 (C_2 + X^2)} \exp\left( - D_2 X^2 \right)$$

$$\text{mit } X = t - \frac{T180}{2} \text{ und } t \, \varepsilon \, [o, T180],$$

wobei $A_2$, $B_2$, $C_2$, $D_2$ und T180 vorbestimmte Parameter sind.

5. Verfahren zur Bestimmung der Form einer ersten temporären Hüllkurve eines Radiofrequenzimpulses, das in einer Vorrichtung zur Bilderzeugung durch magnetische Kernresonanz benutzt wird, wobei die Vorrichtung Mittel, um ein im wesentlichen gleichförmiges magnetisches Feld in einer Raumzone zu erzeugen, Mittel, um diesem Feld Feldgradienten von verschiedenen gewählten Eigenschaften beim Ablauf der aufeinanderfolgenden Datenerfassungssequenzen zu überlagern, Mittel zur Ausstrahlung einer Radiofrequenz, um mindestens einen Radiofrequenzimpuls anzuwenden, der die Form dieser ersten Hüllkurve beim Ablauf jeder Sequenz hat, und Modulationsmittel (M, 11, 12) enthält, um dem Radiofrequenzimpuls diese erste temporäre Hüllkurve zu geben, dadurch gekennzeichnet, dass man eine zweite temporäre Hüllkurve (Fig. 1a) bestimmt, die geometrisch der gewünschten Form für ein Schnittprofil (Fig. 1d) entspricht, und dass man die Form (Fig. 1c) der ersten Hüllkurve des anzuwendenden Radiofrequenzimpulses, ausgehend von der Form des Schnittprofils (Fig. 1b), auswählt, das durch die Anwendung eines Impulses bestimmt ist, der altemporäre Hüllkurve die zweite Hüllkurve hat.

6. Verfahren nach Anspruch 5, dadurch gekennzeichnet, dass die Form des Schnittprofils dank der Vorrichtung zur Bilderzeugung der magnetischen Kernresonanz durch Messung bestimmt wird.

7. Verfahren nach Anspruch 6, dadurch gekennzeichnet, dass die Form (Fig. 1b) der ersten Hüllkurve durch Rechnung bestimmt wird.

8. Verfahren nach einem der Ansprüche 5 bis 7, dadurch gekennzeichnet, dass die erste Hüllkurve des Radiofrequenzsignals von der Form des Schnittprofils abgeleitet wird, das erstens durch die Anwendung der zweiten Hüllkurve des Radiofrequenzimpulses und zweitens durch Multiplikation mit einer Gaussfuntion und/oder durch symmetrisches Abschneiden auf beiden Seiten der Maximalamplitude bestimmt wird.

## Claims

1. An image producing apparatus using nuclear magnetic resonance, comprising means in order to create a substantially uniform magnetic field in a region of space, means to superpose field gradients, of different selected characteristics, on this field, during the course of successive sequences of acquisition of data, RF transmission means in order to transmit at least one RF pulse during the course of each sequence, and modulation means (M, 11 and 12) in order to bestow a time envelope on the said RF pulse, said envelope being deduced geometrically from the profile of section which would result from the application of a RF pulse with an envelope geometrically representative of the profile of the desired section.

2. The apparatus in accordance with claim 1, characterized in that the said envelope has been deduced from the section selection form which would result from the application of a RF pulse with an envelope representative of the desired section selection form by multiplication with a gaussian function and/or by symmetrically truncating it on both sides of its maximum amplitude.

3. The apparatus in accordance with claim 1 or claim 2, characterized in that the said envelope of a RF signal is calibrated in order to cause 90° spin swing and is of the form:

$$F(t) = A_1 \sin c \left( B_1 \sqrt{C_1 + X^2} \right) \exp \left( - D_1 X^2 \right)$$

$$\text{with } X = t - \frac{T90}{2} \text{ and } t \, \varepsilon \, [O, T90]$$

$A_1$, $B_1$, $C_1$, $D_1$ and
T90 being predetermined parameters.

4. The apparatus as claimed in claim 1 or claim 2, characterized in that the said envelope of a RF signal is calibrated in order to cause 180° spin swing and is of the form:

$$F(t) = - A_2 \frac{\cos B_2 \sqrt{C_2 + X^2}}{B_2^2 (C_2 + X^2)} \exp \left( - D_2 X^2 \right)$$

$$\text{with } X = t - \frac{T180}{2} \text{ and } t \, \varepsilon \, [o, T180], \quad A_2, B_2, C_2, D_2$$

and T180 being predetermined parameters.

5. A method for the determination of the form of a first time envelope of the RF pulse used in a nuclear magnetic resonance image producing apparatus, the said apparatus comprising means to create a substantially uniform magnetic field in a space region, means for superposing field gradients with different selected characteristics on this field during the course of successive data acquisition sequences, RF transmission means in order to apply at least one RF pulse having the form of this first envelope during the course of each sequence, and modulation means (M, 11 and 12) in order to bestow this first time envelope on the said RF pulse, characterized in that a second time envelope is determined corresponding geometrically to the desired form of a section profile (figure 1d), and in that the form (figure 1c) of the first RF pulse envelope (figure 1a) is determined which is to be applied starting with the form (figure 1b) of the section profile determined by the application of a pulse having the said second envelope as its time envelope.

6. The method as claimed in claim 5, characterized in that the form of the section profile is determined by a measurement, produced with the nuclear magnetic resonance image producing apparatus.

7. The method as claimed in claim 4, characterized in that the form (figure 1b) of the first envelope is determined by calculation.

8. The method as claimed in any one of the claims 5 through 7, characterized in that the first envelope of the RF pulse is deduced from the form of the section profile determined firstly by the application of the second envelope of the RF pulse and secondly by multiplication by a Gaussian function and/or by symmetrically truncating on both sides of the maximum amplitude.

# FIG_1-a

I

t

# FIG_1-b

M(3)

3

# FIG_1-c

$I_0$

t

# FIG_1-d

$M_0(3)$

3

# FIG_2

13

M

11

12

S